# EUROPÄISCHE PATENTSCHRIFT

(11) **EP 1 335 491 B1**
(45) Veröffentlichungstag und Bekanntmachung des Hinweises auf die Patenterteilung: **28.10.2009**
(21) Anmeldenummer: 03001053.2
(22) Anmeldetag: 17.01.2003
(51) Int. Cl.: H03K 5/1254

(54) **Schaltungsanordnung zur Signalentprellung**
Circuit arrangement for signal debouncing
Circuit anti-rebond de signal

(30) Priorität: 17.01.2002 DE 10201648
(43) Veröffentlichungstag der Anmeldung: 13.08.2003
(73) Patentinhaber: SIEMENS AKTIENGESELLSCHAFT, 80333 München (DE)
(72) Erfinder: Reichmann, Eckehard, 76187 Karlsruhe (DE)

(56) Entgegenhaltungen:
- EP-A- 0 589 655

## Beschreibung

Die Erfindung betrifft eine Schaltungsanordnung nach dem Oberbegriff von Patentanspruch 1. Weiter betrifft die Erfindung ein Verfahren zur Entprellung von Eingangssignalen nach dem Oberbegriff von Patentanspruch 6 und eine Automatisierungsanlage nach dem Oberbegriff von Patentanspruch 7.

Automatisierungsanlagen verfügen meist über mehrere Signalgeber, die Signalzustände erzeugen. Diese Signalgeber können als mechanische Taster ausgeführt sein, die die Eigenschaft aufweisen, beim Betätigen zwischen den Signalzuständen hin und her zu wechseln. Dieses Wechseln zwischen den Signalzuständen wird auch als Prellen bezeichnet, demzufolge wird das Entgegenwirken gegen das Prellen als Entprellen bezeichnet.

Ohne Entprellung kann ein Wechsel zwischen den Signalzuständen als eine Mehrfachbetätigung eines Schalters oder Tasters aufgefasst werden, was bei nachfolgenden Schaltungsanordnungen zu Fehlfunktionen führen kann. Die Eingangssignale werden häufig Mikroprozessoren zugeführt, auf denen eine Software ausgeführt wird, in der durch diese Mehrfachbetätigung Fehlfunktionen hervorgerufen werden können.

Um diese Probleme zu vermeiden, war es bisher bekannt, jedes Signal mittels eines eigenen Zählers zu überprüfen, in dem das Signal erst zur Weiterverarbeitung freigegeben wurde, wenn es in einer Mindestzeit störungsfrei oder stabil war. Das störungsfreie Signal wird dann dem Mikroprozessor zugeführt, so dass die Software mit dem störungsfreien und stabilen Signal diesbezüglich fehlerfrei arbeiten kann.

In der US 4,523,104 wird eine Anordnung beschrieben, bei der die Signalzustände in ein Schieberegister eingelesen werden und diese Signalzustände einer NAND-Verknüpfung zugeführt werden. Das Verknüpfungsergebnis stellt ein korrektes entprelltes Ausgangssignal dar.

In der EP 0 589 655 wird ein Verfahren und eine Vorrichtung zum Entprellen von mehreren Signalen mit einem Filter zum gleichzeitigen Verarbeiten von Signalen und zur Erzeugung von mehreren entprellten Signalen beschrieben. Dabei werden mehrere Eingangssignale über getaktete Gatter in ein Register eingelesen. Eine von der Verarbeitungsbreite des verwendeten Mikroprozessors abhängige Anzahl von Eingängen kann somit gleichzeitig bearbeitet werden. Für jedes Eingangssignal sind unterschiedliche Filterlaufzeiten realisierbar. Um mehrere gefilterte bzw. entprellte Ausgangssignale zu generieren, wird eine aufwendige boolsche Verknüpfungsarithmetik angewendet.

Bei der zunehmenden Komplexität und Geschwindigkeit, mit der derartige Automatisierungsanlagen betrieben werden, ist eine Überwachung der Stabilität der Signalzustände unabdingbar. Des Weiteren ist eine einfache aber flexible Erzeugung entprellter Signale wünschenswert.

Aufgabe der Erfindung ist es deshalb, eine Anordnung und ein Verfahren anzugeben, mit denen auf einfache Art und Weise mehrere Eingangssignale entprellt werden können.

Diese Aufgabe wird durch eine Schaltungsanordnung zur Entprellung von Eingangssignalen gemäß dem Gegenstand des Patentanspruchs 1 gelöst.

Der Erfindung liegt der Gedanke zugrunde, unterschiedliche Signalzustände von mehreren Eingangssignalen in einer gemeinsamen Speicheranordnung zu speichern. Mittels der gemeinsamen Speicheranordnung lässt sich eine effektive Verarbeitung bzw. Verknüpfung der eingelesenen Signalzustände realisieren, so dass durch feststehende logische Operationen die in den Spalten der Speicheranordnung gespeicherten unterschiedlichen Signalzustände eines Eingangssignals mit den unterschiedlichen Signalzuständen eines anderen Eingangssignals verarbeitet werden können. So werden die jeweils einzelnen Signalzustände in einer Zeile, die Signalzustände von unterschiedlichen Eingangssignalen darstellen, mit den Signalzuständen einer anderen Zeile verknüpft. Durch das Verknüpfungsergebnis kann eine Aussage über die Stabilität der gespeicherten Signalzustände getroffen werden.

Das Verfahren ist sehr flexibel in Bezug auf die Anzahl der zu überwachenden Eingangssignale und auf die zu überwachende Zeit der Signalzustände. Mehrere Signalzustände können parallel gleichzeitig überwacht werden, es müssen keine einzelnen Zähler verwaltet werden. Außerdem steht mit diesem Verfahren eine größere Anzahl von Signalen auf einfache Art und Weise zur Weiterverarbeitung zur Verfügung.

Dazu werden in regelmäßigen Abständen die Signalzustände der einzelnen Eingangssignale in die Speicheranordnung eingelesen. Diese Speicheranordnung verfügt über M Spalten, wobei die Anzahl M der Anzahl der einzulesenden Eingangssignale entspricht. Weiterhin weist die Speicheranordnung N Zeilen auf, wobei die Zahl N der Anzahl der einzelnen einzutragenden Signalzustände eines Eingangssignals entspricht. Dabei ist die Zahl N vom zu erfassenden Zeitraum der Signalzustände und vom Abfrageabstand abhängig.

Zur Erkennung der Stabilität des betrachteten Eingangssignals werden die einzelnen Signalzustände miteinander logisch verknüpft. Dadurch bleibt die Speicheranordnung in ihrer Organisation gleich. Durch Variation in der Anzahl der zu verknüpfenden Zeilen und durch die Verwendung von Masken bei der Verknüpfung wird somit trotz der starren Speicheranordnung eine ausreichende Flexibilität erreicht. Andererseits ist es dadurch möglich, den Speichervorgang unaufwendig zu gestalten. Ebenso ist die Zuführung der einzelnen Einträge zur logischen Verknüpfung grundsätzlich immer gleich.

Die zeitlich älteste Zeile von Einträgen der Signalzustände wird durch die neu einzulesenden Einträge überschrieben. Dadurch muss nur für den Einschreib- oder Speichervorgang ein Zeiger mitgeführt werden, der jeweils auf die älteste Zeile hinweist. Die Einträge der Signalzustände selbst werden nach der Speicherung nicht mehr verändert oder verschoben. Damit erfolgt die Auswertung und damit die Erzeugung der entprellten Signale immer auf der gleichen Position und der gleichen Struktur, unabhängig davon, wo der zuletzt eingetragene Signalzustand gespeichert wurde.

Die Einträge der Signalzustände einer Spalte werden beispielsweise einer UND-Verknüpfung oder einer ODER-Verknüpfung unterzogen. Dabei können alle Signalzustände einer Spalte miteinander verknüpft werden. Es ist jedoch auch unter entsprechenden Bedingungen möglich, beispielsweise nur die Signalzustände jeder zweiten Zeile miteinander zu verknüpfen. Dies könnte dann praktisch sein, wenn die Anzahl N der Zeilen sehr groß ist und die Zeit, in der die Stabilität des betrachteten Eingangssignals festgestellt werden muss, sehr klein ist.

Liefert die UND-Verknüpfung der Signalzustände einer Spalte als Ergebnis eine 1, kann daraus gefolgert werden, dass die Signalzustände im überwachten Zeitraum ständig den Signalzustand 1 hatten, ein Ergebnis = 0 bedeutet: im überwachten Zeitraum war der Signalzustand wenigstens einmal ein 0-Zustand.

Liefert die ODER-Verknüpfung der Signalzustände einer Spalte als Ergebnis eine 0, kann daraus gefolgert werden, dass die Signalzustände im überwachten Zeitraum ständig den Zustand 0 hatten, ein Ergebnis = 1 bedeutet: im überwachten Zeitraum war der Signalzustand wenigstens einmal ein 1-Zustand.

Erfindungsgemäß werden die Signalzustände einer Zeile zeitgleich der logischen Verknüpfung zugeführt. Dadurch erhält man für alle zu überwachenden Eingangssignale gleichzeitig ein Ergebnis.

Das Verknüpfungsergebnis kann vorzugsweise mit dem alten Signalzustand verknüpft werden.

Falls durch einen prozessbedingten Umstand oder eine verkürzte Zeitüberwachung eine sofortige Aussage über die Stabilität der bisher eingelesenen Signale erforderlich ist, kann sofort der letzte eingelesene Signalzustand mit dem alten Signalzustand verknüpft werden, so dass sofort eine Aussage über die Stabilität des betrachteten Eingangssignals möglich ist.

In einer weiteren vorteilhaften Ausgestaltung der Erfindung kann die Abtastzeit zwischen den einzelnen Eingangssignalen frei gewählt werden, so dass trotz zeitlich unterschiedlicher Abstände zwischen den Zeitpunkten der Abtastung der Eingangssignale eine gemeinsame Verarbeitung erfolgen kann. Gerade bei komplexen Automatisierungsanlagen ist es erforderlich, die einzelnen zu überwachenden Eingangssignale zu unterschiedlichen Zeitpunkten abzufragen, da eine Vielzahl von unterschiedlichen Signalen erzeugt werden, die alle einer Entprellung unterzogen werden müssen.

Die Aufgabe wird auch durch ein Verfahren zur Entprellung von Eingangssignalen gemäß dem Gegenstand des Patentanspruchs 6 gelöst.

Die Aufgabe wird auch durch eine Automatisierungsanlage gemäß dem Gegenstand von Patentanspruch 7 gelöst.

Bevorzugte Weiterbildungen der Erfindung sind in den Unteransprüchen beschrieben.

Weitere Vorteile und Einzelheiten ergeben sich aus der nachfolgenden Beschreibung eines Ausführungsbeispiels.

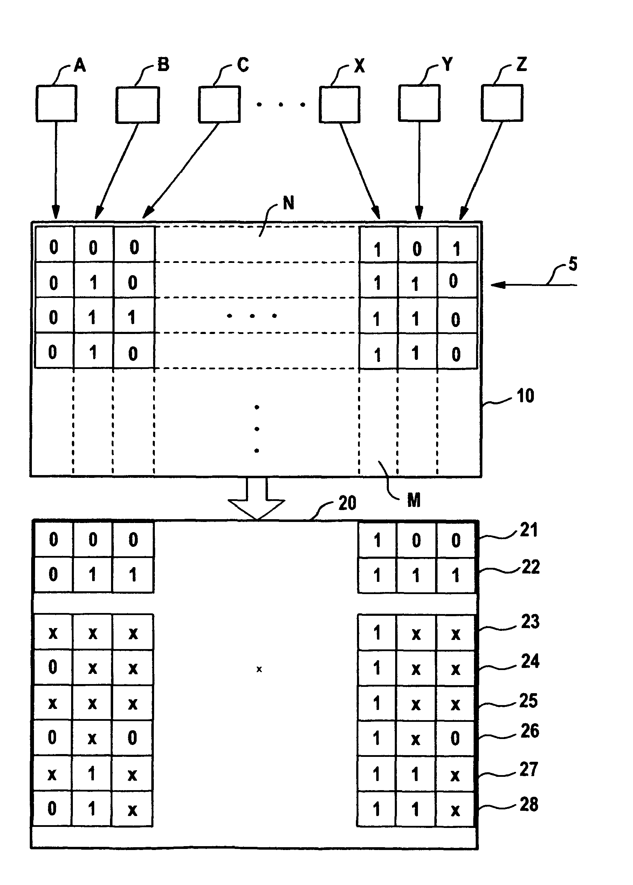

Die Erfindung wird nachstehend ohne Beschränkung des allgemeinen Erfindungsgedankens anhand eines Ausführungsbeispieles unter Bezugnahme auf die Zeichnung exemplarisch beschrieben, auf die im Übrigen bezüglich der Offenbarung aller im Text nicht näher erläuterten erfindungsgemäßen Einzelheiten ausdrücklich verwiesen wird.

Die Figur zeigt den Aufbau einer erfindungsgemäßen Automatisierungsanlage.

In der Figur ist eine erfindungsgemäße Speicheranordnung 10 dargestellt. Dabei stellen die Signale A-Z die Eingangssignale dar, die von nicht explizit dargestellten Signalgebern erzeugt werden, wobei die Eingangssignale A-Z der Speicheranordnung 10 zugeführt werden. Die Eingangssignale A-Z werden mittels des Zeigers 5 immer in der Zeile N gespeichert, die die zeitlich ältesten Einträge der Signalzustände der Eingangssignale enthält. Die Einträge der Speicheranordnung 10 werden der Verknüpfungseinheit 20 zugeführt, in der logische Verknüpfungen der M Einträge der N Zeilen vorgenommen werden. Dabei wird die logische Verknüpfung unabhängig von der zeitlichen Reihenfolge der Speicherung vorgenommen. Es werden dabei wenigstens zwei Einträge, vorzugsweise alle Einträge einer Spalte M miteinander verknüpft. Das heißt, alle M Einträge der zweiten Zeile, die momentan die zuletzt eingeschriebenen Signalzustände darstellen, werden zeilenweise mit allen Einträgen der jeweiligen Spalte einer anderen Zeile verknüpft. Das Ergebnis einer UND-Verknüpfung aller Einträge der M Spalten ist mit 21 gekennzeichnet. Das Ergebnis einer ODER-Verknüpfung aller Einträge der M Spalten ist mit 22 gekennzeichnet. Der Signalzustand kann in einer Anzeigevorrichtung angezeigt werden, wobei eine Anzeige jedoch nicht zwingend erforderlich ist, da für die Übernahme und Weiterverarbeitung der entprellten Signalzustände durch ein Hard- oder Softwaremodul eine visuelle Anzeige nicht erforderlich ist.

Zur Feststellung, ob ein Eingangssignal störungsfrei ist, gelten folgende Regeln:
- UND-Verknüpfung 21:: Ergebnis = 1: ständiger 1-Zustand im überwachten Zeitraum;
Ergebnis = 0: mindestens einmal 0-Zustand im überwachten Zeitraum.
- ODER-Verknüpfung 22:: Ergebnis = 0: ständiger 0-Zustand im überwachten Zeitraum;
Ergebnis = 1: mindestens einmal
1-Zustand im überwachten Zeitraum.

Zur Übernahme eines Signalzustandes als entprelltes Signal wird folgende Regel angewendet:

Neuer Signalzustand = "Alter Signalzustand" ODER (Ergebnis 21) UND (Ergebnis 22).

Mit 23 ist die Verknüpfung "Alter Signalzustand" ODER Ergebnis 21 bezeichnet. Die UND-Verknüpfung von Ergebnis 23 mit Ergebnis 22 ist mit 24 bezeichnet, wobei Ergebnis 24 den neuen, zu übernehmenden Signalzustand darstellt. Als alter Signalzustand wird angenommen, dass dieser für alle M Einträge undefiniert (x) ist.
Das Ergebnis 24 lässt sich folgendermaßen interpretieren: Das Eingangssignal A ist im überwachten Zeitraum störungsfrei bzw. stabil mit Signalzustand 0. Das Eingangssignal X ist ebenfalls störungsfrei bzw. stabil und weist den Signalzustand 1 auf. Für die Eingangssignale B, C, Y, Z kann die Aussage getroffen werden, da diese im Überwachungszeitraum ohne einen stabilen Pegel bzw. Signalzustand waren.

Bei sofortiger Reaktion oder verkürzter Überwachungszeit für die Signalzustände ist nur der zuletzt eingetragene Eintrag, auf den Zeiger 5 zeigt, zu berücksichtigen.

Ergebnis 25 zeigt die ODER-Verknüpfung der alten Signalzustände mit dem Ergebnis 21. Ergebnis 26 zeigt die UND-Verknüpfung von Ergebnis 25 mit den Einträgen der zuletzt gespeicherten Zeile 5. Hier kann abgeleitet werden, dass Eingangssignal X störungsfrei mit Signalzustand 1 ist, die Eingangssignale A, C und Z aktuell den Signalzustand 0 aufweisen und sofort übernommen werden können und die Eingangssignale B und Y im überwachten Zeitraum ohne stabilen Pegel 1 waren.

Eine andere Möglichkeit der Verknüpfung ist mit den Ergebnissen 27 und 28 gezeigt.
Dabei stellt Ergebnis 27 die ODER-Verknüpfung der aktuellen Einträge der Zeile 5 mit den alten Signalzuständen dar, die auch hier als undefiniert (x) angenommen werden.
Aus diesem Ergebnis 27 kann gefolgert werden, dass die Signalzustände der Eingangssignale B, X und Y sofort mit dem Pegel 1 übernommen werden können. Nachdem Ergebnis 27 mit dem Ergebnis 22 der ODER-Verknüpfung der Einträge UND verknüpft wurde, ergibt sich, dass das Eingangssignal A auch entstört bzw. stabil mit dem Pegel 0 ist. Die Eingangssignale C und Z sind im überwachten Zustand instabil.

## Patentansprüche

1. Schaltungsanordnung zur Entprellung von Eingangssignalen (A-Z)
mit einer Speicheranordnung (10), die als Matrix mit wenigstens M Spalten und N Zeilen, mit M, N > 1 organisiert ist, bei der vorgesehen ist, Signalzustände eines Eingangssignals jeweils einer Spalte M zuzuführen und als Eintrag zu speichern, und bei der in Abhängigkeit wenigstens einer logischen Verknüpfung von wenigstens zwei Einträgen einer Spalte die Stabilität des Eingangssignals ableitbar ist, wobei eine Speicherung der aktuell einzulesenden Signalzustände in der Zeile (5) mit den zeitlich ältesten Einträgen vorgesehen ist, **dadurch gekennzeichnet, dass** eine zeitgleiche logische Verknüpfung der jeweils m Einträge einer Zeile mehrerer Eingangssignale mit den m Einträgen mehrerer Eingangssignale einer anderen Zeile vorgesehen ist.

2. Schaltungsanordnung nach Anspruch 1, **dadurch gekennzeichnet, dass** eine Abspeicherung der Eingangssignale in festlegbaren Abständen vorgesehen ist.

3. Anordnung nach Anspruch 1, **dadurch gekennzeichnet, dass** die logische Verknüpfung der Einträge eine logische UND-Verknüpfung und/oder eine logische ODER-Verknüpfung von wenigstens zwei Einträgen jeweils einer Spalte umfasst.

4. Anordnung nach Anspruch 1, **dadurch gekennzeichnet, dass** ein Vergleich der Ergebnisse der logischen Verknüpfung mit den ursprünglichen Signalzuständen der Eingangssignale vorgesehen ist.

5. Anordnung nach Anspruch 1, **dadurch gekennzeichnet, dass** die logische Verknüpfung unabhängig von der zeitlichen Reihenfolge der Speicherung der Einträge erfolgt.

6. Verfahren zur Entprellung von Eingangssignalen, bei dem jeweils zeitlich aufeinander folgende Signalzustände mehrerer Eingangssignale als Einträge in eine Speicheranordnung eingelesen und die Einträge des jeweiligen Eingangssignals logisch miteinander verknüpft werden, um eine Aussage über die Stabilität des Signalzustandes des betrachteten Eingangssignals zu erhalten, wobei die mehreren Eingangssignale in jeweils M Spalten der Speicheranordnung und die zeitlich aufeinander folgenden Einträge in N Zeilen der Speicheranordnung eingelesen werden und jeweils die zeitlich älteste Zeile N der Einträge überschrieben wird, **dadurch gekennzeichnet, dass** die m Einträge einer Zeile zeitgleich wenigstens mit den m Einträgen einer anderen Zeile logisch miteinander verknüpft werden.

7. Automatisierungsanlage mit wenigstens einem Signalgeber, der zu unterschiedlichen Zeiten abtastbar ist und Signalzustände liefert,
wobei wenigstens ein Ausgangssignal erzeugt wird, welches die Stabilität der Signalzustände des wenigstens einen Eingangssignals angibt, **gekennzeichnet durch** eine Schaltungsanordnung gemäß Anspruch 1 mit einer gemeinsamen Speicheranordnung, in der die Signalzustände speicherbar sind.

## Claims

1. Circuit arrangement for debouncing input signals (A-Z) having a storage array (10) which is organised as a matrix having at least M columns and N rows, where M, N > 1, wherein it is provided for signal states of an input signal to be supplied in each case to a column M and stored as an entry, and wherein the stability of the input signal can be derived as a function of at least one logical operation combining at least two entries of a column, with provision being made for the signal states that are currently to be read in to be stored in the row (5) with the chronologically oldest entries, **characterised in that** provision is made for a simultaneous logical operation combining the in each case m entries of a row of a plurality of input signals with the m entries of a plurality of input signals of another row.

2. Circuit arrangement according to claim 1, **characterised in that** provision is made for the input signals to be stored at definable intervals.

3. Arrangement according to claim 1, **characterised in that** the logical operation combining the entries comprises a logical ANDing and/or a logical ORing of at least two entries of one column in each case.

4. Arrangement according to claim 1, **characterised in that** provision is made for the results of the logical operation to be compared with the original signal states of the input signals is provided.

5. Arrangement according to claim 1, **characterised in that** the logical operation is performed irrespective of the chronological sequence in which the entries are stored.

6. Method for debouncing input signals, wherein in each case chronologically sequential signal states of a plurality of input signals are read in as entries into a storage array and the entries of the respective input signal are logically combined with one another in order to reach an assessment concerning the stability of the signal state of the input signal that is under consideration, wherein the plurality of input signals are read into M columns of the storage array in each case and the chronologically sequential entries are read into N rows of the storage array and the chronologically oldest row N of the entries is overwritten in each case, **characterised in that** the m entries of a row are logically combined with one another simultaneously at least with the m entries of a different row.

7. Automation system having at least one signal transmitter which can be sampled at different times and supplies signal states,
wherein at least one output signal is generated which indicates the stability of the signal states of the at least one input signal, **characterised by** a circuit arrangement according to claim 1 having a shared storage array in which the signal states can be stored.

## Revendications

1. Circuit anti-rebond de signaux ( A-Z ) d'entrée
comprenant un dispositif ( 10 ) de mémoire, qui est organisé en matrice ayant au moins M colonnes et N lignes, avec M, N > 1, dans lequel il est prévu d'envoyer des états d'un signal d'entrée respectivement à une colonne M et de les mémoriser comme entrées, et dans lequel, en fonction d'au moins une combinaison logique d'au moins deux entrées d'une colonne, la stabilité du signal d'entrée peut être déduite, dans lequel il est prévu une mémorisation des états de signal à lire instantanément dans la ligne ( 5 ) avec les entrées les plus vieilles dans le temps, **caractérisé en ce qu'**il est prévu une combinaison logique en même temps des respectivement m entrées d'une ligne de plusieurs signaux d'entrée avec les m entrées de plusieurs signaux d'entrée d'une autre ligne.

2. Circuit suivant la revendication 1, **caractérisé en ce qu'**il est prévu une mémorisation des signaux d'entrée à des intervalles pouvant être fixés.

3. Circuit suivant la revendication 1, **caractérisé en ce que** la combinaison logique des entrées comprend une combinaison logique ET et/ou une combinaison logique OU d'au moins deux entrées dans respectivement une colonne.

4. Circuit suivant la revendication 1, **caractérisé en ce qu'**il est prévu une comparaison des résultats de la combinaison logique avec les états d'origine des signaux d'entrée.

5. Circuit suivant la revendication 1, **caractérisé en ce que** la combinaison logique s'effectue indépendamment de la succession dans le temps de la mémorisation des entrées.

6. Procédé d'anti-rebond de signaux d'entrée, dans lequel des états de signal se succédant respectivement dans le temps de plusieurs signaux d'entrée sont lus comme entrées dans un dispositif de mémoire et les entrées du signal d'entrée respectif sont combinées logiquement entre elles pour obtenir une déduction sur la stabilité de l'état du signal d'entrée considéré, dans lequel on lit les plusieurs signaux d'entrée dans respectivement M colonnes du dispositif de mémoire et les entrées se succédant dans le temps dans N lignes du dispositif de mémoire et on écrase respectivement les lignes N des données les plus vieilles dans le temps, **caractérisé en ce que** l'on combine logiquement entre elles les m entrées d'une ligne en même temps qu'au moins les m entrées d'une autre ligne.

7. Installation d'automatisation ayant au moins un indicateur de signal, qui peut être échantillonné à des intervalles de temps différents et qui fournit des états de signal,
dans lequel il est produit au moins un signal de sortie qui indique la stabilité des états du au moins un signal d'entrée, **caractérisé par** un circuit suivant la revendication 1 ayant un dispositif de mémoire commun, dans lequel les états de signal peuvent être mémorisés.
